(19) **Europäisches Patentamt European Patent Office Office européen des brevets**

(11) **EP 1 857 576 B1**

(12) **EUROPÄISCHE PATENTSCHRIFT**

(45) Veröffentlichungstag und Bekanntmachung des Hinweises auf die Patenterteilung:
**05.01.2011 Patentblatt 2011/01**

(51) Int Cl.:
*C30B 33/00* (2006.01)　　*G01B 11/06* (2006.01)
*H01L 21/306* (2006.01)

(21) Anmeldenummer: **07008863.8**

(22) Anmeldetag: **02.05.2007**

(54) **Verfahren zur Behandlung einer Halbleiterscheibe**

Method for treating a semi-conductor wafer

Procédé destinés au traitement d'une tranche semi-conductrice

(84) Benannte Vertragsstaaten:
**DE FR**

(30) Priorität: **18.05.2006 DE 102006023497**

(43) Veröffentlichungstag der Anmeldung:
**21.11.2007 Patentblatt 2007/47**

(73) Patentinhaber: **Siltronic AG**
**81737 München (DE)**

(72) Erfinder:
• **Murphy, Brian**
**84347 Pfarrkirchen (DE)**

• **Feijóo, Diego, Dr.**
**84489 Burghausen (DE)**
• **Wahlich, Reinhold**
**84523 Tittmoning (DE)**

(74) Vertreter: **Baar, Christian et al**
**c/o Siltronic AG**
**Corporate Intellectual Property**
**Hanns-Seidel-Platz 4**
**81737 München (DE)**

(56) Entgegenhaltungen:
EP-A- 0 511 777　　JP-A- 9 008 258
JP-A- 9 232 279　　US-A1- 2006 097 355
US-B1- 6 224 934

EP 1 857 576 B1

**Beschreibung**

Die vorliegende Erfindung bezieht sich auf ein Verfahren und eine Vorrichtung zur Behandlung einer Halbleiterscheibe mittels einer Oxidation mit lokal unterschiedlicher Oxidationsrate.

Eine Halbleiterscheibe, insbesondere eine einkristalline Siliciumscheibe für die Verwendung in der Halbleiterindustrie, muss eine hohe Ebenheit aufweisen, insbesondere um den Anforderungen für die Herstellung integrierter Schaltkreise Rechnung zu tragen. Eine allgemein anerkannte Faustregel besagt, dass der $SFQR_{max}$-Wert einer Halbleiterscheibe nicht größer sein darf als die Linienbreite der Bauelemente, die auf der Halbleiterscheibe hergestellt werden sollen. Um eine möglichst große Anzahl von Schaltkreisen integrieren zu können, muss die geforderte Ebenheit außerdem möglichst nahe bis an den Rand der Vorderseite gewährleistet sein, wobei die Vorderseite als die Seite definiert ist, auf der die Bauelemente hergestellt werden sollen. Dies bedeutet, dass die Messung der Ebenheit mit sehr geringem Randausschluss durchzuführen ist und die spezifizierten Ebenheitswerte nicht nur für die sog. Full Sites, sondern auch für die Partial Sites erfüllt sein müssen. (Full Sites sind alle Flächenelemente, auf denen vollständige Bauelemente gefertigt werden können, Partial Sites sind die Flächenelemente am Scheibenrand, auf denen keine vollständigen Bauelemente Platz finden.)

Bei der Definition der Ebenheit von Halbleiterscheiben wird gemäß der SEMI-Norm M1-94 zwischen globaler und lokaler Ebenheit unterschieden. Die globale Ebenheit bezieht sich auf die gesamte Scheibenoberfläche abzüglich eines zu definierenden Randausschlusses. Sie wird durch den GBIR ("global backsurfacereferenced ideal plane/range" = Bereich der positiven und negativen Abweichung von einer rückseitenbezogenen Idealebene für die gesamte Vorderseite der Halbleiterscheibe) beschrieben, welcher der früher gebräuchlichen Angabe TTV ("total thickness variation") entspricht. Die lokale Ebenheit bezieht sich auf eine begrenzte Fläche auf der Halbleiterscheibe, die in der Regel der Fläche des darauf zu errichtenden Bauelements entspricht. Sie wird oft als SFQR ("site front surface referenced least squares/range" = Bereich der positiven und negativen Abweichung von einer über Fehlerquadratminimierung definierten Vorderseite für eine Fläche definierter Dimension) ausgedrückt. Die Größe $SFQR_{max}$ gibt den höchsten SFQR-Wert für alle Bauelementeflächen auf einer bestimmten Halbleiterscheibe an. Beim SFQR ist immer anzugeben, auf welche Fläche sich der angegebene Wert bezieht, beispielsweise auf eine Fläche von 26 x 8 $mm^2$ gemäß der ITRS-Roadmap.

Ein weiterer Ebenheitsparameter ist die sog. Nanotopographie. Diese ist definiert als peak-to-valley-Abweichung in einem vorgegebenen Flächenelement, z. B. 2 x 2 $mm^2$. Die Nanotopographie wird unter Verwendung von Messgeräten wie ADE CR 83 SQM, ADE PhaseShift Nanomapper oder KLA Tencor SNT gemessen.

Die Ebenheit im Randbereich der Halbleiterscheibe wird durch den sog. "Edge Roll off" entscheidend beeinflusst. "A New Method for the Precise Measurement of Wafer Roll off of Silicon Polished Wafer", Jpn.J.Appl.Phys., Vol. 38 (1999), Seite 38-39 beschreibt die Messung des "Wafer Roll off" (= Edge Roll off). Der Edge Roll off kann sowohl auf der Vorderseite als auch auf der Rückseite der Halbleiterscheibe auftreten. Er kann die SFQR-Werte der am Scheibenrand gelegenen Flächenelemente deutlich beeinflussen. Ein Edge Roll off ist insbesondere bei Halbleiterscheiben störend, die, beispielsweise zur Herstellung von SOI-Scheiben, mit einer weiteren Halbleiterscheibe verbunden (gebondet) werden, da der Edge Roll off der miteinander zu verbindenden Scheibenflächen großen Einfluss auf die Bondqualität am Scheibenrand hat.

Derzeit werden Halbleiterscheiben, die als Substrat für die Herstellung mikroelektronischer Bauelemente dienen, in der Regel nach der folgenden konventionellen Prozesssequenz hergestellt: Sägen, Läppen und/oder Schleifen, nasschemisches Ätzen, Abtragspolitur (engl. "stock removal polishing") und Endpolitur (engl. "mirror polishing"). Es hat sich gezeigt, dass diese Prozesssequenz nicht in der Lage ist, die für die ständig abnehmenden Linienbreiten erforderlichen Ebenheiten zu gewährleisten.

In der EP798766A1 wird in der konventionellen Prozesssequenz zwischen Abtragspolitur und Endpolitur ein Gasphasenätzschritt nach dem PACE-Verfahren ("plasma assisted chemical etching") gefolgt von einer Wärmebehandlung eingefügt, um die Ebenheit der Halbleiterscheibe zu verbessern. Anhand der Prozessierung von Siliciumscheiben mit einem Durchmesser von 200 mm wird gezeigt, dass die beschriebene Prozesssequenz GBIR-Resultate von 0,2 - 0,3 μm ermöglicht. Lokale Ebenheitsdaten sind nicht angegeben. Weiterhin ist nicht angegeben, wie groß der Randausschluss der Ebenheitsmessung war.

In der EP961314A1 ist ein ähnliches Verfahren angegeben, bei dem nach Sägen, Schleifen, PACE und Endpolitur GBIR-Werte von bestenfalls 0,14 μm und $SFQR_{max}$-Werte von bestenfalls 0,07 μm erreicht werden.

Das PACE-Verfahren, wie in EP961314A1 vorgeschlagen, führt zu einer Verschlechterung der Rauhigkeit bei einer polierten Scheibe, die teilweise durch einen zusätzlichen Hydrophobierungsschritt unmittelbar vor dem PACE reduziert werden kann. PACE muss im Vakuum durchgeführt werden, was den Prozess anlagentechnisch aufwändig macht. Außerdem wird die Halbleiterscheibe mit den Zersetzungsprodukten der zum Ätzen verwendeten Gase kontaminiert, was einen zusätzlichen Reinigungsschritt notwendig macht, wie in EP1100117A2 beschrieben. Zudem erfolgt dieser Prozess nicht vollflächig, sondern durch Abrastern der Halbleiterscheibe. Dies ist einerseits sehr zeitaufwändig und führt andererseits zu Problemen bezüglich der Nanotopographie im Überlappungsbereich des Abrasterns sowie bezüglich der Ebenheit ($SFQR_{max}$ und Edge Roll off) im äußeren Bereich der Halbleiterscheibe bis zu einer Entfernung von ca. 5 mm vom Scheibenrand. Eine mögliche Ursache ist die verstärkte Absaugwirkung am Rand der Halbleiterscheibe und damit Reduzierung des Ätzmediums, da im Vakuum gearbeitet wird. Durch die notwendige Überlappung beim Abrastern verschlechtert sich an den Überlappungspositionen insbesondere die Nanotopographie. Je größer der Durchmesser der Düse ist, mit der das Ätzmedium zugeführt wird, umso deutlicher ist die Verschlechterung. Aus wirtschaftlichen Gründen kann der Düsendurchmesser jedoch nicht beliebig klein gewählt werden.

Die im Stand der Technik bekannten Verfahren sind somit nicht in der Lage, die Geometrieanforderungen für Bauelemente mit Linienbreiten gleich oder kleiner 65 nm, d. h. $SFQR_{max}$-Werte von höchstens 65 nm, zu erfüllen. Die schwerwiegendsten Probleme treten dabei im Randbereich der Halbleiterscheibe auf, da der Randausschluss von derzeit 3 mm (bei Linienbreiten von 90 nm) bei den zukünftigen Linienbreiten von 65 nm oder weniger auf 2 mm bzw. 1 mm reduziert wird und die Partial Sites bei der Beurteilung der Ebenheit einbezogen werden.

Ein zusätzliches Problem ergibt sich im Fall von sog. SOI-Scheiben. Diese Halbleiterscheiben weisen eine Halbleiterschicht auf, die sich auf einer Fläche einer Trägerscheibe (engl. "base wafer" oder "handle wafer") befindet. Die Dicke der Halbleiterschicht variiert abhängig von den zu prozessierenden Bauelementen. Generell wird zwischen sog. "dünnen Schichten" (weniger als 100 nm Dicke) und sog. "dicken Schichten" (von 100 nm bis ca. 80 $\mu$m) unterschieden. Die Trägerscheibe kann entweder vollständig aus einem elektrisch isolierenden Material bestehen (z. B. Glas, Quarz, Saphir) oder sie kann beispielsweise aus einem Halbleitermaterial, vorzugsweise aus Silicium, bestehen und lediglich durch eine elektrisch isolierende Schicht von der Halbleiterschicht getrennt sein. Die elektrisch isolierende Schicht kann beispielsweise aus Siliciumoxid bestehen.

SOI-Scheiben sind von großer Wichtigkeit für die Herstellung mikroelektronischer Bauelemente. Die Halbleiterschicht einer SOI-Scheibe muss eine sehr homogene Dicke bis in den äußersten Randbereich aufweisen. Insbesondere bei Halbleiterschichten mit einer Dicke von 100 nm oder weniger variieren die Transistoreigenschaften, wie z. B. die Einsatzspannung, im Fall inhomogener Schichtdicken sehr stark. Die absolute Dickentoleranz bei SOI-Scheiben mit dünnen und dicken Halbleiterschichten hängt von der Schichtdicke ab. Als Messmethode für die Schichtdicke wird bevorzugt spektroskopische Ellipsometrie, Reflektometrie oder Interferometrie verwendet.

Um eine möglichst große Anzahl von Schaltkreisen integrieren zu können, muss zudem die notwendige Schichtdickenhomogenität möglichst nahe bis an den Rand der Vorderseite gewährleistet sein. Dies bedeutet wiederum einen sehr geringen Randausschluss.

Es sind auch Verfahren zur Nachbehandlung einer SOI-Scheibe mit dem Ziel der Verbesserung der Schichtdickenhomogenität bekannt. Dabei handelt es sich generell um lokale Ätzverfahren unter Abrastern der SOI-Scheibe, wobei an Stellen höherer Schichtdicke ein höherer Ätzabtrag vorgesehen ist: Gemäß US2004/0063329A1 wird in einem Trockenätzverfahren die Oberfläche der SOI-Scheibe mit einer Düse abgerastert, über die ein gasförmiges Ätzmedium lokal zugeführt wird. In EP488642A2 und EP511777A1 sind Verfahren beschrieben, in denen die Halbleiterschicht der SOI-Scheibe ganzflächig einem Ätzmedium ausgesetzt wird. Dieses Ätzmedium muss jedoch durch einen Laserstrahl oder einen mit einem optischen System fokussierten Lichtstrahl einer Lichtquelle lokal unter Abrastern der Oberfläche aktiviert werden (photochemisches Ätzen).

Alle Verfahren, bei denen die Oberfläche der Halbleiterschicht abgerastert werden muss, um einen lokal unterschiedlichen Ätzabtrag zu erreichen, sind sehr zeit- und damit kostenintensiv. Außerdem erfordert das Abrastern eine aufwändige Bewegung der Lichtquelle bzw. der Düse einerseits oder der SOI-Scheibe andererseits.

Zudem treten besonders im Randbereich der Scheibe, d. h. in einem Bereich bis zu 5 mm Entfernung vom Scheibenrand sowie in den Bereichen, in denen beim Abrastern die Überlappung geschieht, zusätzliche Inhomogenitäten der Schichtdicke auf. Bei einer Schichtdicke von 520 nm wird gemäß EP488642A2 eine Schichtdickenhomogenität von 10 nm ohne Angabe eines Randausschlusses erreicht. Gemäß EP511777A1 wird bei einer Schichtdicke von 108 nm eine Schichtdickenhomogenität von 8 nm ohne Angabe eines Randausschlusses erreicht.

In US 2006/0097355 wird ein Verfahren beschrieben, WO eine SOI-Scheibe am selben Moment ertsabhängig unter Belichtung oxidiert und geätzt wird.

JP09232279 und JP09008258 zeigen auch ertsabhängige Ätzverfahren.

Trotz der aufwändigen Verfahren werden somit die notwendigen Schichtdickenhomogenitäten, insbesondere im Randbereich der SOI-Scheibe, nicht erreicht.

Der Erfindung liegt somit die Aufgabe zugrunde, eine Halbleiterscheibe mit verbesserter Ebenheit (insbesondere im Randbereich) und Nanotopographie zur Verfügung zu stellen, die für die Herstellung von Bauelementen mit Linienbreiten von 65 nm oder weniger geeignet ist. Der Begriff "Halbleiterscheibe" umfasst dabei auch eine SOI-Scheibe. Eine weitere Aufgabe besteht darin, eine SOI-Scheibe mit verbesserter Schichtdickenhomogenität, insbesondere im Randbereich, zur Verfügung zu stellen.

Die Aufgabe wird gelöst durch ein Verfahren wie im Anspruch 1 beschrieben.

Gegenstand der Erfindung ist ein Verfahren zur Behandlung einer Halbleiterscheibe durch Oxidation wenigstens einer der Flächen der Halbleiterscheibe und Entfernung der Oxidschicht. Bei diesem Verfahren wird die Fläche der Halbleiterscheibe (bei einer SOI-Scheibe die Halbleiterschicht) im Gegensatz zum Stand der Technik nicht punktuell oder abrasternd behandelt, sondern vollflächig. Die Korrektur des in Schritt a) ortsabhängig gemessenen Parameters wird durch eine ortsabhängige Wachstumsrate der Oxidschicht (im Folgenden auch als Oxidationsrate bezeichnet) in Schritt b) erreicht. Daraus resultiert eine ortsabhängig unterschiedliche Dicke der Oxidschicht, die anschließend in Schritt c) vorzugsweise vollständig entfernt wird. Durch Oxidation und Entfernung der Oxidschicht wird ortsabhängig unterschiedlich viel Material abgetragen. Die zur Korrektur erforderliche lokal unterschiedliche Oxidationsrate wird durch eine lokal unterschiedliche Lichtintensität erreicht. Die lokale Verteilung der Lichtintensität wird durch die lokalen Werte des zuvor gemessenen Parameters bestimmt. Der Parameter, der im erfindungsgemäßen Verfahren optimiert werden soll, wird in Schritt a) gemessen. Die daraus resultierenden Messwerte werden zur Steuerung der lokalen Lichtintensität verwendet.

Das erfindungsgemäße Verfahren ist auf alle Halbleiterscheiben anwendbar, beispielsweise bestehend aus Germanium, bevorzugt aus Silicium-Germanium oder Siliciumcarbid. Besonders bevorzugt ist die Anwendung auf Silicium. Soll die Ebenheit der Vorderseite einer derartigen Halbleiterscheibe verbessert werden, so eignet sich als Parameter, der in Schritt a) des Verfahrens gemessen wird, die Höhenabweichung von einer definierten Idealebene, wie oben beschrieben. Diese Höhenabweichung kann mit einem herkömmlichen Geometriemessgerät bestimmt werden.

Soll die globale Ebenheit (GBIR) einer Halbleiterscheibe optimiert werden, wird in Schritt a) die Abweichung der Scheibenvorderseite von einer durch die Scheibenrückseite definierten Idealebene bestimmt und in Schritt b) die lokale Lichtintensität so gesteuert, dass an lokalen Erhebungen eine hohe Oxidationsrate und an Orten lokaler Vertiefungen eine niedrige Oxidationsrate erzielt wird.

Soll dagegen die lokale Ebenheit (SFQR) einer Halbleiterscheibe optimiert werden, wird in Schritt a) die Abweichung der Scheibenvorderseite von einer auf ein bestimmtes Messfenster, beispielsweise der Größe 26 x 8 mm$^2$, bezogenen Idealebene bestimmt und in Schritt b) die lokale Lichtintensität so gesteuert, dass an lokalen Erhebungen eine hohe Oxidationsrate und an Orten lokaler Vertiefungen eine niedrige Oxidationsrate erzielt wird.

Das erfindungsgemäße Verfahren ist auch auf SOI-Scheiben anwendbar, wobei die Halbleiterschicht der SOI-Scheibe beispielsweise aus Germanium bestehen kann. Bevorzugt ist die Anwendung auf Halbleiterschichten, die aus Silicium-Germanium oder Siliciumcarbid bestehen, besonders bevorzugt ist die Anwendung auf Silicium. Soll die Schichtdickenhomogenität der Halbleiterschicht verbessert werden, so wird diese Schichtdicke in Schritt a) des erfindungsgemäßen Verfahrens gemessen. Die Dicke der Halbleiterschicht kann beispielsweise mit einem Ellipsometer, Interferometer oder Reflektometer ortsabhängig gemessen werden. Im folgenden Schritt b) wird die lokale Lichtintensität so gesteuert, dass an Orten großer Schichtdicke eine hohe Oxidationsrate und an Orten geringer Schichtdicke eine niedrige Oxidationsrate erzielt wird.

Anhand der Messung in Schritt a) wird für jeden Punkt auf der Fläche der Halbleiterscheibe der notwendige Materialabtrag bestimmt. Aus der von der Lichtintensität abhängigen Oxidationsrate, die das verwendete Ätzmedium beim betreffenden Halbleitermaterial erzielt und die wiederum den Materialabtrag definiert, lässt sich sowohl die erforderliche Dauer der Oxidationsbehandlung als auch für jeden Punkt auf der Fläche der Halbleiterscheibe die erforderliche Lichtintensität berechnen.

Generell richtet sich die Anzahl und Position der Messpunkte nach der gewünschten Auflösung. Die Anzahl der maximal möglichen Messpunkte hängt von der Größe der Messsonde ab. Beispielsweise beträgt die Größe der Messsonde bei den Messgeräten ADE 9500 (für Halbleiterscheiben mit einem Durchmesser von 200 mm) und ADE AFS (für Halbleiterscheiben mit einem Durchmesser von 300 mm) 2 x 2 mm$^2$.

Aus den Messwerten wird anschließend die erforderliche lokale Lichtintensität berechnet. Ein geeignetes Verfahren wird im Folgenden anhand von Geometriedaten, d. h. für eine Optimierung des GBIR oder SFQR, beschrieben, es ist aber sinngemäß auch auf Nanotopographie-Daten oder die Schichtdicke einer Halbleiterschicht im Fall einer SOI-Scheibe anwendbar.

Das Geometriemessgerät misst mit einer Messsonde der Größe AxA (typischerweise 4 x 4 mm$^2$ oder 2 x 2 mm$^2$) ein vollständiges Mapping der Dicke t der Halbleiterscheibe mit einem Durchmesser D. Die Dicke t ist dabei genau genommen die Höhenabweichung von einer durch die Rückseite der Halbleiterscheibe definierten Idealebene. Diese Daten können als Rohdaten vom Geometriemessgerät auf einen Computer übertragen werden. Legt man nun ein kartesisches Koordinatensystem durch die Mitte der Halbleiterscheibe, so existiert zu jedem Punkt x,y ein Wert der Dicke, t(x,y). Dabei wird x und y im Raster der Messfenstergröße variiert, was bedeutet, dass t(x,y) als Mittelwert der Dicke über das Quadrat, definiert durch x-A/2 bis x+A/2 und y-A/2 bis y+A/2 zu verstehen ist. Die Belichtungsvorrichtung besitzt eine Auflösung von BxB Bildpunkten, beispielsweise 1024 x 1024. Mit Hilfe einer Computer-internen Matrix der Größe BxB wird jedem Matrixelement M(a,b) der entsprechende Wert aus der originalen Dickenmatrix zugeordnet:

$$M(a,b) = t(|-D/2+a*D/B|, \; |-D/2+b*D/B|) \qquad (1)$$

Dabei symbolisiert || die Betragsfunktion. Die Betragsfunktion ist anwendbar, da typischerweise die Auflösung der Belichtungsvorrichtung größer ist als die der originalen Dickendaten. Im entgegen gesetzten Fall ist einfach eine geometrische Mittelung der originalen Daten durchzuführen.

Nach dieser Transformation werden die Daten geglättet. Als Kontrollparameter existiert der Mittelungsradius R. Dem Bildpunkt mit den Koordinaten i,j wird der Mittelwert aus allen Bildpunkten zugeordnet, die in einen Kreis mit Radius R um den Punkt i,j liegen. Ein Punkt x,y liegt genau dann im Kreis um i,j, wenn folgende Bedingung erfüllt ist:

$$(i-x)*(i-x)+(j-y)*(j-y) \leq R*R \qquad (2)$$

Der neue Wert berechnet sich aus dem Mittelwert aller M(x,y), die obige Bedingung erfüllen:

$$M_{smooth}(i,j) = Mittelwert(M(x_1,y_1), M(x_2,y_2), M(x_3,y_3), \ldots M(x_n,y_n))$$
$$(3)$$

R liegt, bezogen auf das Ursprungskoordinatensystem, typischerweise zwischen 0,1 cm und 2 cm und dient als Tuningparameter.

Neben dieser geometrischen Glättung können aber auch alle anderen Standardverfahren zur Glättung durchgeführt werden, die Allgemeingut der EDV sind.

Der Maximalwert $Max_M$ und Minimalwert $Min_M$ der Matrix $M_{Smooth}$ erlauben die Erzeugung der Graustufenmatrix für die Belichtung der Halbleiterscheibe:

$$\text{Transparenzanteil des Bildpunkts i,j =}$$
$$(M_{smooth}(i,j)-Min_M)*(Max_M-Min_M)*100\% \qquad (4)$$

$$\text{Schwarzanteil des Bildpunkts i,j =}$$
$$100\%-(M_{smooth}(i,j)-Min_M)*(Max_M-Min_M)*100\% \qquad (5)$$

Durch diesen Algorithmus werden besonders dicke Stellen der Halbleiterscheibe als durchsichtig dargestellt, sodass diese Stellen mit einer hohen Lichtintensität belichtet werden. Dagegen werden die dünnsten Stellen schwarz dargestellt und damit nicht oder nur mit einer geringen Lichtintensität belichtet.

Die Erfindung macht sich die Abhängigkeit der Geschwindigkeit bestimmter Oxidationsreaktionen von der Intensität und der Wellenlänge des eingestrahlten Lichts zu Nutze. Dies wird im Folgenden am Beispiel von Silicium konkret beschrieben. Die Erfindung ist jedoch auch auf andere Halbleitermaterialien anwendbar.

Die Geschwindigkeit der thermischen Oxidation von Silicium wird im Wesentlichen durch 1) die Bildung reaktiver oxidierender Spezies, 2) durch die Diffusion dieser Spezies von der Scheibenoberfläche zur in die Siliciumscheibe hineinwachsenden Grenzfläche zwischen Silicium und Siliciumoxid sowie 3) durch die Bildung von Siliciumoxid an dieser Grenzfläche bestimmt. Es ist bekannt, dass eine oder mehrere dieser Reaktionsschritte und damit die Geschwindigkeit von Oxidationsreaktionen durch die Einstrahlung von Licht geeigneter Wellenlänge beschleunigt werden können.

Der Einfluss der Lichtintensität und Wellenlänge sowie die zu Grunde liegenden Oxidationsmodelle wurden von Young et al. und Kazor et al. beschrieben (Young et al., Applied Physic Letters 50(2) (1987), Seite 80; Kazor et al., Applied Surface Science 54 (1992), Seite 460-464).

Das in Schritt b) eingesetzte Oxidationsmittel ist vorzugsweise gasförmig. Ein besonders bevorzugtes Oxidationsmittel ist Sauerstoff ($O_2$). Stickstoffoxide wie Distickstoffmonoxid ($N_2O$) sind auch geeignet. Die Gasatmosphäre kann zudem weitere reaktive Gase wie Wasserstoff ($H_2$) oder Chlor ($Cl_2$) sowie nicht reaktive Gase wie Stickstoff ($N_2$) oder Edelgase enthalten. Sie kann auch Wasserdampf ($H_2O$) enthalten - in diesem Fall spricht man von einer feuchten Oxidation. Beispielsweise kann die Oxidation auch mit Luft durchgeführt werden.

Ist das Oxidationsmittel Sauerstoff, so führt eine Bestrahlung mit UV-Licht mit einer Wellenlänge von weniger als 250 nm zu einem Brechen der Sauerstoff-Sauerstoff-Bindung, sodass sehr reaktiver monoatomarer Sauerstoff (O) sowie Ozon ($O_3$) entsteht. Dieser Effekt nimmt mit abnehmender Wellenlänge zu, sodass der Einsatz von Licht mit einer Wellenlänge von weniger als 200 nm bevorzugt ist, wenn Sauerstoff als Oxidationsmittel verwendet wird. Monoatomarer Sauerstoff (O) und Ozon ($O_3$) sind wesentlich stärkere Oxidationsmittel als molekularer Sauerstoff ($O_2$). Daher kann die Oxidationsrate durch Bestrahlung mit UV-Licht im genannten Wellenlängenbereich deutlich beschleunigt werden. Dieser Einfluss wurde von Boyd et al. beschrieben (Boyd et al., Nuclear Instruments and Methods in Physic Research B 121 (1997), Seite 349-356).

Ozon und monoatomarer Sauerstoff haben eine sehr kurze Lebensdauer, die mit steigender Temperatur weiter abnimmt. Die Oxidationsbehandlung in Schritt b) wird vorzugsweise bei Temperaturen von 100 bis 1100 °C und besonders bevorzugt bei 300 bis 500 °C durchgeführt. Bei diesen Temperaturen ist die Lebensdauer der genannten reaktiven Sauerstoff-Spezies so kurz, dass es nach ihrer Erzeugung nicht zu einer nennenswerten Diffusion dieser Spezies kommt.

Durch eine ortsabhängige Intensität des UV-Lichts kann an verschiedenen Orten eine verschiedene Menge dieser reaktiven Sauerstoff-Spezies erzeugt werden. Da die Diffusion dieser Spezies praktisch keine Rolle spielt, wird dadurch auch eine ortsabhängige, unterschiedliche Konzentration dieser Spezies und damit eine ortsabhängige Oxidationsrate erreicht.

Auch beim Einsatz von Licht mit größeren Wellenlängen kann über einen Einfluss auf die Schritte 2) und 3) der Oxidationsreaktion eine Ortsabhängigkeit der Oxidationsrate erreicht werden. Der größte Effekt kann jedoch durch Wellenlängen unter 250 nm und insbesondere unter 200 nm und deren Einfluss auf Schritt 1) der Oxidationsreaktion erzielt werden.

Die spektrale Abhängigkeit der Absorption ist wichtig für die Auswahl einer geeigneten Lichtquelle zur Ausführung der Erfindung. Beispielsweise zeichnen sich Lichtbogenlampen durch ein breites Spektrum und hohe Intensitäten aus, sie sind also gut brauchbar für die Belichtung ganzer Halbleiterscheiben. Durch Verwendung von geeigneten Filtern (Hochpass, Tiefpass) kann der passende Wellenlängenbereich eingestellt werden. Grundsätzlich können jedoch alle Lichtquellen verwendet werden, deren Licht dazu geeignet ist, die oben genannten Wirkungen zu erzielen. Es eignen sich beispielsweise auch Niederdruck-Quecksilber-Lampen oder Natriumdampflampen, Deuteriumlampen, Excimer-Lampen, Laser oder LEDs. Wenn beim Einsatz von Sauerstoff als Oxidationsmittel durch die ortsabhängige Belichtung in erster Linie die Entstehung reaktiver Sauerstoff-Spezies (wie oben beschrieben) beeinflusst werden soll, sind Lichtquellen zu bevorzugen, die einen Anteil ihres Lichts unter 250 nm oder sogar unter 200 nm Wellenlänge emittieren, beispielsweise Deuteriumlampen, Excimer-Lampen oder Niederdruck-Quecksilber-Lampen.

Es existieren mehrere Möglichkeiten, in Schritt b) des erfindungsgemäßen Verfahrens eine ortsabhängig unterschiedliche Belichtung zu realisieren:

Beispielsweise kann eine Belichtungsvorrichtung mit einer einzigen Lichtquelle verwendet werden, wobei die Ortsabhängigkeit der Belichtung durch Filter mit ortsabhängiger Transmission oder Spiegel mit ortsabhängiger Reflektivität erreicht wird. Die Matrix der berechneten Graustufen kann durch die Belichtungsvorrichtung mit Hilfe einer geeigneten Optik scharf auf die Oberfläche der Halbleiterscheibe projiziert und damit zur Steuerung der lokalen Lichtintensität verwendet werden. Die Optik wird vorzugsweise so ausgelegt, dass die zu behandelnde Fläche der Halbleiterscheibe möglichst homogen ganzflächig belichtet wird, d. h. vorzugsweise mit Abweichungen von weniger als ± 10 %, wenn sich kein Filter mit ortsabhängiger Transmission bzw. kein Spiegel mit ortsabhängiger Reflektivität zwischen Lichtquelle und Halbleiterscheibe befindet. Alternativ können durch die Lichtquelle oder die Optik bedingte Belichtungs-Inhomogenitäten im Algorithmus für die Berechnung der Graustufen berücksichtigt und somit kompensiert werden.

In einer Ausführungsform der Erfindung werden die in Schritt a) erhaltenen Messergebnisse einer Halbleiterscheibe zur Herstellung eines exakt auf diese Halbleiterscheibe angepassten Filters verwendet, der anschließend für die Belichtung dieser einen Halbleiterscheibe eingesetzt wird. Die Graustufen des Filters können mit dem oben beschriebenen Algorithmus berechnet werden. Der Filter selbst kann auf verschiedene Weise erzeugt werden, beispielsweise durch Herstellung einer Filterfolie im Druckverfahren. Der Filter wird zur Belichtung der Halbleiterscheibe, für die er hergestellt wurde, in geeigneter Weise und in richtiger Orientierung so zwischen Lichtquelle und Halbleiterscheibe angebracht, dass der Filter exakt auf der Halbleiterscheibe abgebildet wird.

Alternativ kann auch ein LCD-Filter verwendet werden, bei dem die Transmission ortsabhängig durch Anlegen einer elektrischen Spannung variiert werden kann.

Prinzipiell sind jedoch alle Filterarten geeignet, die eine Transmission von annähernd 0 bis 100 % zulassen und eine geeignete lokale Auflösung erlauben.

Anstelle eines Filters mit örtlich unterschiedlicher Lichtdurchlässigkeit kann auch ein entsprechend hergestellter Spiegel mit örtlich unterschiedlicher Reflektivität eingesetzt werden.

Die Herstellung eines Filters oder eines Spiegels, der jeweils nur für eine Halbleiterscheibe verwendet werden kann, ist sehr aufwändig. Aus diesem Grund ist folgende Ausführungsform der Erfindung für Wellenlängen ≥ 250 nm besonders bevorzugt: Aus dem in Schritt a) gemessenen ortsabhängigen Wert des Parameters wird mit Hilfe einer Steuereinheit, vorzugsweise eines Computers, eine Graustufenkarte berechnet. Dazu kann der oben beschriebene Algorithmus verwendet werden. Die Belichtung der Halbleiterscheibe in Schritt b) erfolgt durch eine Projektionsvorrichtung, die ein Bild dieser Graustufenkarte auf die Fläche der Halbleiterscheibe projiziert. Die Belichtungsvorrichtung ist in diesem Fall eine Projektionsvorrichtung, die ohne Verwendung eines festen Filters oder Spiegels das Bild der Graustufenkarte direkt auf die Halbleiterscheibe projizieren kann. Die Projektionsvorrichtung arbeitet vorzugsweise nach dem Prinzip eines Daten- oder Videoprojektors (sog. "Beamer"). Dabei wird das Licht der Projektionslampe durch einen ansteuerbaren Spiegelchip (eine Matrix aus vielen hunderttausend mikroskopisch kleinen Spiegeln auf einem wenige $cm^2$ großen Chip) umgelenkt. Eine derartige Projektionsvorrichtung, wie sie derzeit kommerziell erhältlich ist, ermöglicht beispielsweise eine Steuerung der Lichtdurchlässigkeit in einem Bereich von 0 bis 100 % mit einer Auflösung von 1024 x 768 Punkten. Dies ergibt auf der Oberfläche einer zu behandelnden Halbleiterscheibe mit einem Durchmesser von 300 mm eine Dichte von ca. 6,5 Punkten/$mm^2$.

Für kleinere Wellenlängen, insbesondere für Wellenlängen unter 250 nm, ist es zunehmend schwierig, ein geeignetes Material für Spiegel zu finden. In diesem Fall ist es besonders vorteilhaft, die lokalen Unterschiede in der Lichtintensität durch ein Array einer Vielzahl nebeneinander angeordneter Lichtquellen zu erzeugen, wobei die Lichtquellen die Halbleiterscheibe direkt oder durch einen zusätzlichen Filter bestrahlen. Die Lichtquellen werden einzeln oder in Gruppen so gesteuert, dass die an jedem Ort auf der Fläche der Halbleiterscheibe einwirkende Lichtintensität in einem eindeutigen Zusammenhang mit dem ortsabhängigen Wert des in Schritt a) gemessenen Parameters steht. Ein Array von Lichtquellen kann auch bei größeren Wellenlängen, d. h. Wellenlängen ab 250 nm, verwendet werden.

Die Lichtquellen sind bei jeder der genannten Ausführungsformen so zu wählen, dass der gewünschte lokale Unterschied in der Oxidationsrate ausreichend ist, um eine sehr ebene Grenzfläche zwischen Halbleitermaterial und Oxid zu ermöglichen. Die Oxidationsrate ist abhängig von der Temperatur, der Wellenlänge, der Lichtintensität und von der Art und der Konzentration des Oxidationsmittels.

Das Oxidationsmittel bzw. die Zusammensetzung der Atmosphäre ist in Kombination mit dem verwendeten Lichtwellenlängenbereich und in Abhängigkeit vom Halbleitermaterial so zu wählen, dass eine ausreichend starke Abhängigkeit der Oxidationsrate von der Lichtintensität und Wellenlänge besteht. Typische Oxidationsbedingungen für niedrige Temperaturen (unter 550 °C) wurden von Kazor et al. (Applied Surface Science 54 (1992), Seite 460-464) und Ishikawa et al. (Jpn. J. Appl. Phys. 30 (1991) L661) beschrieben. Die Abhängigkeit der Oxidationsrate von der Wellenlänge wurde von Young et al. (Applied Physics Letters 50(2) (1987), Seite 12) beschrieben.

Durch Vorversuche kann ein geeigneter Parametersatz für die Oxidationsbehandlung ermittelt werden. (Kazor et al., Applied Surface Science 54 (1992), Seite 460-464; Boyd et al, Nuclear Instruments and Methods in Physics Research B 121 (1997), Seite 349-356).

Für die ortsabhängige Oxidation von Silicium eignet sich im Rahmen des erfindungsgemäßen Verfahrens beispielsweise Sauerstoff als Oxidationsmittel. Er wird der Oxidationskammer vorzugsweise in einem Fluss von 100 bis 1000 $cm^3$/min, vorzugsweise 150 bis 600 $cm^3$/min, zugeführt. Der bevorzugte Druckbereich ist von der Lichtwellenlänge abhängig. Bei einer Wellenlänge von 185 nm oder mehr kann unter Atmosphärendruck oder verringertem Druck gearbeitet werden. Bei geringeren Wellenlängen ist ein verringerter Druck, vorzugsweise von weniger als 100 hPa, wegen der erhöhten Absorption durch den Sauerstoff bevorzugt. Die Lebensdauer des aus den Sauerstoff-Molekülen unter UV-Bestrahlung gebildeten Ozons ist bei verringertem Druck größer, andererseits ist die Ortsabhängigkeit der Ozonkonzentration bei Atmosphärendruck aufgrund der geringeren Lebensdauer besser definiert. Die konkreten Bedingungen sind deshalb an die Aufgabenstellung anzupassen.

In Abhängigkeit von den anderen Parametern der Oxidationsbehandlung wird die Intensität des eingestrahlten Lichts so gewählt, dass die gewünschte Oxidationsrate erreicht wird. Möglich ist eine lokale Intensität von 0 W/$cm^2$ bis 10 W/$cm^2$ (bei Lasern), bevorzugt sind 0 bis 100 mW/$cm^2$ und besonders bevorzugt 0 bis 30 mW/$cm^2$. Eine für die Oxidation von Silicium bevorzugte Lichtquelle ist die Niederdruck-Quecksilber-Lampe, die bei Wellenlängen von 185 und 254 nm emittiert.

Um eine ausreichende Oxidationsrate zu erzielen, ist eine Temperatur von 300 bis 500 °C während der Oxidationsbehandlung bevorzugt. Bei diesen Temperaturen sind abhängig von der Lichtintensität Oxidationsraten von 2 bis 6 nm pro Stunde möglich. Um die üblicherweise erforderlichen Oxidschichtdicken zu erreichen, ist eine Behandlungsdauer von etwa 1 bis 4 Stunden erforderlich.

Um die Oxidationsrate weiter zu erhöhen, können auch höhere Temperaturen im Bereich von 500 °C bis 1100 °C eingesetzt werden (Oren et al., Journal of applied Physics 42(2) (1971), Seite 752-756; Young et al., Applied Physics Letters, 50(2) (1987), Seite 80).

Eventuell auftretende Strömungsinhomogenitäten des Oxidationsmittels, die am Rand der Halbleiterscheibe zu einem abweichenden Materialabtrag führen können, können durch eine entsprechende Korrektur der lokalen Lichtintensität ausgeglichen werden.

Die Oxidschicht wird anschließend in Schritt c) entfernt. Vorzugsweise wird die Oxidschicht in Schritt c) vollständig entfernt. Dies geschieht vorzugsweise durch ein geeignetes Ätzverfahren. Das Ätzverfahren kann ein Gasphasenätzverfahren, ein nasschemisches Ätzverfahren oder ein Plasmaätzverfahren sein. Die Bedingungen werden vorzugsweise so gewählt, dass das Ätzverfahren nur das Oxid, nicht aber das Halbleitermaterial selbst angreift. Ist das Halbleitermaterial Silicium, kann dies durch den Einsatz einer wässrigen Lösung erreicht werden, die Fluorwasserstoff (HF) enthält. In Abwesenheit von Oxidationsmitteln greift Fluorwasserstoff nur Siliciumoxid, nicht aber Silicium an.

Da die Oxidation und die Entfernung der Oxidschicht jeweils ganzflächig ablaufen, kann ein zeitintensives Abrastern der Oberfläche vermieden werden. Damit ist das erfindungsgemäße Verfahren kostengünstig durchzuführen. Da die Abstufung und örtliche Auflösung der ortsabhängigen Lichtintensität sehr fein gewählt werden kann, können die beim Abrastern gemäß dem Stand der Technik auftretenden Überlappungseffekte vermieden werden.

Das Verfahren hat den Vorteil, dass es lokal korrigierend bis zum Rand der Halbleiterscheibe arbeitet, sodass die erforderliche Qualität bis zum Scheibenrand erreicht wird. Insbesondere ist es möglich, die geforderte Ebenheit oder Schichtdicke bei einem Randausschluss von 2 mm oder weniger und unter Einbeziehung der Partial Sites zu erreichen.

Das Verfahren eignet sich sowohl zum Entfernen von Inhomogenitäten der Halbleiterschicht einer SOI-Scheibe als auch zum Entfernen von Inhomogenitäten einer Halbleiterscheibe einschließlich Edge Roll off. Daher eignen sich die mit Hilfe des erfindungsgemäßen Verfahrens behandelten Halbleiterscheiben auch hervorragend zum Verbinden (Bonden) mit einer weiteren Halbleiterscheibe, da die Bondqualität besonders am Rand von den SFQR-Werten und vom Edge Roll off beeinflusst wird. Die großen wirtschaftlichen Vorteile liegen in der höheren Nutzbarkeit der Scheibenfläche für die Herstellung von Bauelementen. Dies wirkt sich bei SOI-Scheiben aufgrund der deutlich höheren Herstellkosten besonders stark aus.

Das erfindungsgemäße Verfahren wird bei einer SOI-Scheibe in der Regel nur auf der Vorderseite (= die Seite, die die Halbleiterschicht trägt), bei einer Halbleiterscheibe ohne Schichtstruktur bevorzugt auf der Vorderseite durchgeführt. Wenn der Edge Roll off auch auf der Rückseite verringert werden soll, muss das Verfahren auch auf der Rückseite angewendet werden. Das Verfahren kann in diesem Fall sequentiell auf der Vorderseite und der Rückseite oder auf beiden Seiten gleichzeitig angewendet werden.

Bevorzugt wird im Anschluss an das erfindungsgemäße Verfahren keine Politur durchgeführt, um die Ebenheit oder Schichtdickenhomogenität nicht wieder zu verschlechtern. Insbesondere bei SOI-Scheiben mit Silicium-Schichtdicken von weniger als 1 $\mu$m sollte keine Politur durchgeführt werden. Falls eine nachfolgende Politur zur Verringerung der Oberflächenrauhigkeit erforderlich ist, sollte diese mit einem möglichst geringen Polierabtrag verbunden sein, um die Ebenheit der Oberfläche bzw. die Homogenität der Schichtdicke zu erhalten.

Das Verfahren wird bei einer durch Übertragung einer Halbleiterschicht von einer Donorscheibe auf eine Trägerscheibe hergestellten SOI-Scheibe nach dem Verbinden der Scheiben und Trennen der Schicht vom Rest der Donorscheibe durchgeführt. Das erfindungsgemäße Verfahren kann im Fall einer SOI-Scheibe mit einem oder mehreren thermischen Prozessen zur Oberflächenglättung oder zur Verstärkung der Bondkraft und/oder mit einer oder mehreren Oxidationsbehandlungen zur Dünnung der Halbleiterschicht kombiniert werden.

Das erfindungsgemäße Verfahren erlaubt die Herstellung von Halbleiterscheiben mit hervorragend ebener Oberfläche und von SOI-Scheiben mit hervorragender Schichtdickenhomogenität.

Insbesondere erlaubt das erfindungsgemäße Verfahren die Herstellung von Halbleiterscheiben, deren Vorderseiten einen GBIR von höchstens 0,09 $\mu$m, einen $SFQR_{max}$ in einem Messfenster der Größe 26 x 8 mm$^2$ einschließlich Partial Sites von höchstens 0,05 $\mu$m bei einem Randausschluss von 2 mm und einen Edge Roll off auf der Vorderseite von höchstens 0,2 $\mu$m, gemessen in einem Bereich zwischen 1 mm und 3 mm Entfernung vom Rand der Halbleiterscheibe, aufweisen.

Vorzugsweise zeichnen sich die erfindungsgemäß hergestellten Halbleiterscheiben sogar durch einen $SFQR_{max}$ in einem Messfenster der Größe 26 x 8 mm$^2$ einschließlich Partial Sites von höchstens 0,03 $\mu$m bei einem Randausschluss von 2 mm aus.

Die Erfindung erlaubt auch die Herstellung von Halbleiterscheiben, deren Vorderseite eine Nanotopographie (peak to valley) in einem Messfenster der Größe 2 x 2 mm$^2$ von höchstens 16 nm bei einem Randausschluss von 2 mm aufweisen.

Erfindungsgemäß hergestellte, hoch ebene Halbleiterscheiben, insbesondere bestehend aus einkristallinem Silicium, eignen sich für die Verwendung in der Halbleiterindustrie, insbesondere zur Fabrikation von elektronischen Bauelementen mit Linienbreiten von 65 nm oder weniger. Sie eignen sich auch besonders gut als Donorscheiben oder Trägerscheiben zur Herstellung von gebondeten SOI-Scheiben, insbesondere, da die Ebenheit einschließlich Edge Roll off auch bei einem sehr geringen Randausschluss von lediglich 2 mm gewährleistet ist.

Die Erfindung erlaubt auch die Herstellung von SOI-Scheiben, umfassend eine Halbleiterschicht und eine Trägerscheibe, wobei die Halbleiterschicht eine Dicke von weniger als 100 nm aufweist und die relative Standardabweichung von der mittleren Dicke der Halbleiterschicht höchstens 3 % bei einem Randausschluss von 2 mm beträgt. Die relative Standardabweichung der Dicke der Halbleiterschicht wird im Folgenden auch als Schichtdickenhomogenität bezeichnet.

Vorzugsweise zeichnen sich die erfindungsgemäß hergestellten SOI-Scheiben bei einer Schichtdicke von höchstens 100 nm sogar durch eine Schichtdickenhomogenität von höchstens 1 % bei einem Randausschluss von 2 mm aus.

Besonders bevorzugt ist es, das erfindungsgemäße Verfahren zunächst auf die Donorscheibe und die Trägerscheibe anzuwenden, bevor diese miteinander verbunden werden, danach die Trägerscheibe mit der Halbleiterschicht vom Rest der Donorscheibe zu trennen und anschließend die so hergestellte SOI-Scheibe nochmals dem erfindungsgemäßen Verfahren zu unterziehen, um die Dicke der Halbleiterschicht zu homogenisieren. Eine derart hergestellte SOI-Scheibe zeichnet sich zusätzlich zu den oben genannten Eigenschaften durch einen GBIR von höchstens 0,1 $\mu$m und einen $SFQR_{max}$ in einem Messfenster der Größe 26 x 8 mm$^2$ einschließlich Partial Sites von höchstens 53 nm bei einem Randausschluss von 2 mm und einen Edge Roll off auf der Vorderseite von höchstens 0,25 $\mu$m, gemessen in einem Bereich zwischen 1 mm und 3 mm Entfernung vom Rand der Halbleiterscheibe, aus.

Da das erfindungsgemäße Verfahren auch auf SOI-Scheiben mit dicker Halbleiterschicht anwendbar ist, erlaubt es auch die Herstellung von SOI-Scheiben, umfassend eine Halbleiterschicht und eine Trägerscheibe, wobei die Halbleiterschicht eine Dicke im Bereich von 0,1 $\mu$m bis 80 $\mu$m aufweist und die relative Standardabweichung von der mittleren Dicke der Halbleiterschicht höchstens 4 % bei einem Randausschluss von 2 mm beträgt.

Vorzugsweise zeichnet sich die erfindungsgemäß hergestellte SOI-Scheibe mit dicker Halbleiterschicht sogar durch eine Schichtdickenhomogenität von höchstens 2 % bei einem Randausschluss von 2 mm aus.

Wird die SOI-Scheibe, wie oben für SOI-Scheiben mit dünner Halbleiterschicht beschrieben, durch Anwendung des erfindungsgemäßen Verfahrens auf die Donorscheibe und die Trägerscheibe und anschließend auf die SOI-Scheibe hergestellt, was bevorzugt ist, so zeichnet sich die SOI-Scheibe mit dicker Halbleiterschicht zusätzlich durch einen GBIR von höchstens 0,11 $\mu$m und einen $SFQR_{max}$ in einem Messfenster der Größe 26 x 8 mm$^2$ einschließlich Partial Sites von höchstens 55 nm bei einem Randausschluss von 2 mm und einen Edge Roll off auf der Vorderseite von höchstens 0,3 $\mu$m, gemessen in einem Bereich zwischen 1 mm und 3 mm Entfernung vom Rand der SOI-Scheibe, aus.

Außerdem weist eine erfindungsgemäß hergestellte SOI-Scheibe mit dicker oder dünner Halbleiterschicht vorzugsweise eine Nanotopographie (peak to valley) in einem Messfenster der Größe 2 x 2 mm$^2$ von höchstens 16 nm, bevorzugt von höchstens 8 nm und besonders bevorzugt von höchstens 2 nm bei einem Randausschluss von 2 mm auf.

Im Folgenden werden bevorzugte Ausführungsformen des erfindungsgemäßen Verfahrens beschrieben, mit denen der Materialabtrag des Verfahrens erhöht werden kann:

Im Fall von SOI-Scheiben kann es erwünscht sein, durch das erfindungsgemäße Verfahren nicht nur die Homogenität der Schichtdicke zu verbessern, sondern die Schichtdicke auf einen definierten Zielwert hin zu verringern. Dies kann im Rahmen des erfindungsgemäßen Verfahrens durch eine gleichmäßige, ortsunabhängige Erhöhung des in den Schritten b) und c) erzielten Materialabtrags erreicht werden. Dafür gibt es mehrere Möglichkeiten:

Beispielsweise kann zusätzlich zu Schritt b) eine weitere Oxidationsbehandlung mit homogener, nicht ortsabhängiger Oxidationsrate durchgeführt werden. Diese weitere Oxidationsbehandlung kann vor Schritt b), zwischen den Schritten b) und c) oder nach Schritt c) durchgeführt werden. Im ersten Fall kann die Oxidschicht mit homogener Dicke analog zu Schritt c) entfernt werden, bevor in Schritt b) mit der ortsabhängigen Oxidation begonnen wird. Im zweiten Fall wird die gesamte erzeugte Oxidschicht in Schritt c) entfernt. Im dritten Fall wird die zusätzliche Oxidschicht mit homogener Dicke nachfolgend analog zu Schritt c) entfernt. Diese Schritte können auch mehrmals wiederholt werden. Die zusätzliche Oxidationsbehandlung kann zur Erhöhung der Oxidationsrate beispielsweise bei voller Belichtung der Halbleiterscheibe durchgeführt werden. Die Oxidationsrate kann aber auch durch Zuführung von extern erzeugtem Ozon in die Oxidationskammer erhöht werden. Auch die Erzeugung eines Plasmas erhöht die Oxidationsrate.

Die Kombination aus Homogenisierung und Dünnung kann aber auch allein mit den Schritten b) und c) durchgeführt werden. In diesem Fall wird bei der Berechnung der lokal unterschiedlichen Lichtintensität der erforderliche Gesamtabtrag bis zur gewünschten Enddicke berücksichtigt. In Schritt b) kann die Oxidationsrate homogen, also unabhängig vom Ort, durch eine generelle Erhöhung der Lichtintensität, eine Erhöhung der Temperatur, durch gleichzeitige Zuführung extern erzeugten Ozons oder durch Plasmaunterstützung erhöht werden. Durch die in der Oxidationskammer erfolgende ortsabhängige Belichtung wird die erforderliche Ortsabhängigkeit der Oxidationsrate erreicht.

Im Folgenden wird eine zur Durchführung des erfindungsgemäßen Verfahrens besonders gut geeignete Vorrichtung anhand von Figuren beschrieben:

Fig. 1 zeigt schematisch den Aufbau einer erfindungsgemäßen Vorrichtung mit einer Vielzahl von einzelnen Lichtquellen.

Fig. 2 zeigt schematisch den Aufbau einer weiteren erfindungsgemäßen Vorrichtung mit einer Vielzahl von einzelnen Lichtquellen.

Fig. 3 zeigt ein radiales Dickenprofil der Siliciumschicht einer gemäß dem Stand der Technik hergestellten SOI-Scheibe.

Fig. 4 zeigt das radiale Dickenprofil der Siliciumschicht der SOI-Scheibe, nachdem sie dem erfindungsgemäßen Verfahren unterzogen wurde.

Zur Durchführung des erfindungsgemäßen Verfahrens eignet sich insbesondere eine Vorrichtung zur Behandlung einer Halbleiterscheibe 5, umfassend:

- eine Messvorrichtung 11 zur ortsabhängigen Messung eines die Halbleiterscheibe 5 charakterisierenden Parameters,
- eine Oxidationskammer 6 zur Aufnahme der Halbleiterscheibe 5, umfassend eine Haltevorrichtung für die Halbleiterscheibe 5 und ein System 9 zur Zu- und Abführung des Oxidationsmittels,
- eine Belichtungsvorrichtung, die eine Vielzahl von Lichtquellen 2 umfasst, die nebeneinander in einer parallel zur Ebene der Halbleiterscheibe 5 liegenden Ebene angeordnet sind, wobei die Lichtquellen 2 einzeln oder in Gruppen gesteuert werden können, und die so angeordnet ist, dass sie eine Seite der in der Oxidationskammer 6 befindlichen Halbleiterscheibe 5 mit einer ortsabhängigen Lichtintensität belichten kann und
- eine Steuereinheit 10 zur Umrechnung der von der Messvorrichtung 11 ermittelten Werte des Parameters in Anweisungen zur Steuerung der Belichtungsvorrichtung und Weitergabe der Anweisungen an die Belichtungsvorrichtung.

Die steuerbare Belichtungsvorrichtung umfasst eine Vielzahl von Lichtquellen 2. Diese einzelnen Lichtquellen sind nebeneinander in einer parallel zur Ebene der Halbleiterscheibe 5 liegenden Ebene angeordnet und können einzeln oder in Gruppen so gesteuert werden, dass sie eine Seite der in der Oxidationskammer 6 befindlichen Halbleiterscheibe 5 mit einer ortsabhängigen Lichtintensität belichten können. Die einzelnen Lichtquellen können verschiedene Formen aufweisen, beispielsweise ringförmig, kreisförmig, quadratisch oder streifenförmig. Die Lichtquellen können die gleiche Form oder unterschiedliche Formen haben. Die einzelnen Lichtquellen 2 emittieren Licht mit einer definierten Leistung und Wellenlänge.

Als Lichtquellen 2 für diese Belichtungsvorrichtung können beispielsweise Niederdruck-Quecksilber-Lampen verwendet werden, die Licht mit Wellenlängen von 185 und 254 nm emittieren. Die ortsabhängige Lichtintensität auf der Oberfläche der Halbleiterscheibe 5 liegt vorzugsweise im Bereich von 0 bis 30 mW/cm$^2$.

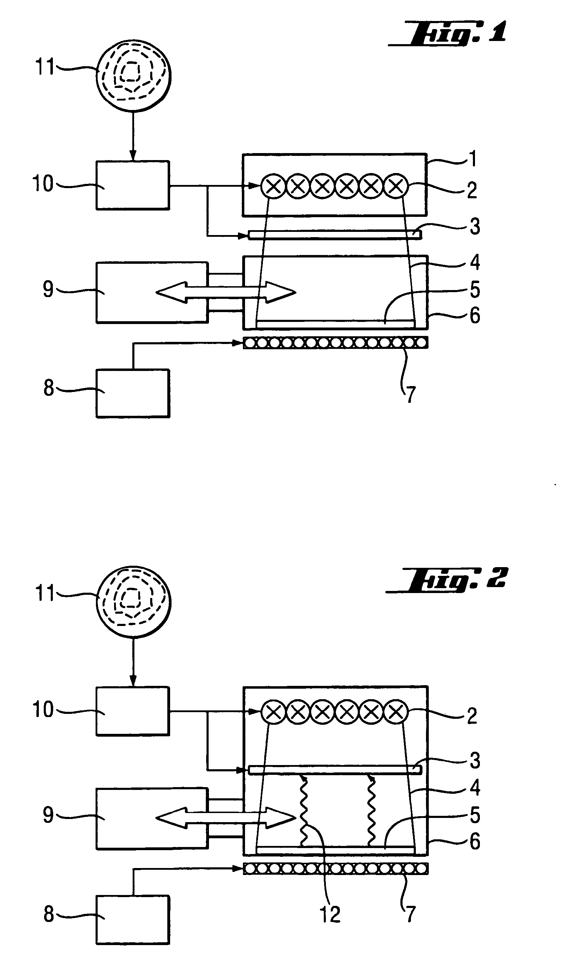

Die Lichtquellen 2 können entweder direkt in der Oxidationskammer 6 (siehe Fig. 2) oder in einem eigenen Gehäuse 1 außerhalb der Oxidationskammer 6 (siehe Fig. 1) angebracht sein.

Zwischen den Lichtquellen 2 und der Halbleiterscheibe 5 kann ein Filter 3 angeordnet sein. Mit diesem Filter kann der Wellenlängenbereich des Lichts eingeschränkt werden. Es kann aber auch ein Filter verwendet werden, der die Einstellung einer ortsabhängig unterschiedlichen Transmission erlaubt, beispielsweise ein LCD-Filter. Es können auch beide Arten von Filtern in Kombination verwendet werden. In dem in Fig. 2 dargestellten Fall befindet sich auch der Filter in der Oxidationskammer 6.

In der in Fig. 2 dargestellten Vorrichtung schützt der Filter die Lichtquellen 2, die sich ebenfalls in der Oxidationskammer befinden, vor Überhitzung durch die von der Halbleiterscheibe emittierte Wärmestrahlung. In der in Fig. 1 dargestellten Anordnung kann eine Überhitzung der Lichtquellen 2 auch durch eine geeignete Materialwahl für das den Lichtquellen zugewandte Oberteil der Oxidationskammer 6 vermieden werden. Beispielsweise kann ein Glas verwendet werden, das für die von den Lichtquellen emittierte Strahlung 4 (vorzugsweise UV-Strahlung) transparent ist und gleichzeitig die von der Halbleiterscheibe emittierte IR-Strahlung 12 absorbiert. Eine Überhitzung der Lichtquellen 2 kann auch durch eine Kühlung der Lichtquellen, beispielsweise durch Luft oder Wasser, vermieden werden.

Die Intensität des Lichts an der Oberfläche der Halbleiterscheibe 5 hängt vom Öffnungswinkel der Lichtquellen 2, vom Abstand der Lichtquellen 2 und der Halbleiterscheibe 5 sowie von der an die Lichtquelle angelegten elektrischen Spannung ab. Die Ausbreitungsrichtung des von den Lichtquellen 2 emittierten Lichts sollte im Wesentlichen senkrecht zur Oberfläche der Halbleiterscheibe 5 sein. Um eine ausreichende Ortsauflösung sicherzustellen, weisen die einzelnen Lichtquellen 2 der Belichtungsvorrichtung vorzugsweise einen möglichst geringen Öffnungswinkel auf, insbesondere bei größerem Abstand zwischen Lichtquellen 2 und Halbleiterscheibe 5. Die Überlappung der Lichtkegel der einzelnen Lichtquellen 2 auf der Halbleiterscheibe 5 sollte vorzugsweise auf die jeweils direkt benachbarten Lichtquellen beschränkt sein. Um dies zu erreichen, können geeignete Linsen, Reflektoren oder Blenden eingesetzt werden. Diese zusätzlichen optischen Bauteile können für jede Lichtquelle einzeln oder für Gruppen von Lichtquellen eingesetzt werden. Typischerweise liegt der Öffnungswinkel zwischen 0° und 10° und der Abstand zwischen den Lichtquellen und der Halbleiterscheibe zwischen 1 und 50 cm.

Die von einer einzelnen Lichtquelle 2 emittierte Lichtintensität kann durch die elektrische Spannung gesteuert werden, die an die Lichtquelle angelegt wird. Abhängig von den geometrischen Randbedingungen wie dem Abstand zwischen Lichtquellen und Halbleiterscheibe oder dem Öffnungswinkel der Lichtquellen wird die an einem bestimmten Ort auf der Oberfläche der Halbleiterscheibe benötigte Lichtintensität durch die an eine individuelle Lichtquelle 2 angelegte Spannung gesteuert. Die individuelle Steuerung jeder einzelnen Lichtquelle ist bevorzugt, um bei der Bestrahlung eine höchstmögliche Auflösung (Schärfe) zu erreichen. Es können aber auch Gruppen von einzelnen Lichtquellen gemeinsam gesteuert werden.

Im Fall der Verwendung der erfindungsgemäßen, in Fig. 1 und 2 schematisch dargestellten Vorrichtungen entspricht die Graustufenmatrix, die auf Basis der in Schritt a) des erfindungsgemäßen Verfahrens erhaltenen Messwerte errechnet wurde, der Matrix der Leistungen der einzelnen Lichtquellen. Bei geringer Überlappung der Lichtkegel ist die Leistung der einzelnen Lichtquelle proportional zum Transparenzanteil des entsprechenden Punkts der Graustufenmatrix.

Die Steuereinheit 10 kann neben der Belichtungseinrichtung 1 und ggf. einem steuerbaren Filter 3 (beispielsweise LCD-Filter) weitere Funktionen der Vorrichtung steuern, wie beispielsweise das Be- und Entladen von Halbleiterscheiben mittels eines Roboters oder die Parameter der Oxidationsbehandlung, wie beispielsweise Temperatur (z. B. über die Heizung 7), Dauer der Oxidationsbehandlung und Fluss des Oxidationsmittels durch das System 9 zur Zuführung des Oxidationsmittels.

Die für die Oxidationsbehandlung verwendete Oxidationskammer 6 kann die Halbleiterscheibe 5 entweder waagrecht liegend oder senkrecht stehend aufnehmen. Um eine (abgesehen von der lokal unterschiedlichen Lichtintensität) homogene Oxidationsrate zu erreichen, kann die Halbleiterscheibe 5 bewegt werden. Beispielsweise ist eine Rotation der Halbleiterscheibe 5 möglich, diese muss jedoch simultan durch die Belichtungsvorrichtung 1 und ggf. durch den Filter 3 nachvollzogen werden, beispielsweise durch eine simultane Rotation. Bevorzugt ist jedoch, die Halbleiterscheibe 5 nicht zu bewegen.

Des weiteren kann eine Kühlung zur Temperaturhomogenisierung eingesetzt werden. Da die Oxidationsbehandlung in der Regel bei erhöhten Temperaturen durchgeführt wird, ist jedoch eine Heizung 7 bevorzugt, die entweder über eine separate Steuerung 8 oder über die Steuereinheit 10 gesteuert wird.

An die Oxidationskammer 6 angeschlossen ist ein System 9 zur Versorgung mit Oxidationsmittel, welches das Oxidationsmittel in der benötigten Menge, Dosierung und Qualität (ggf. Filtration) liefert.

Eine in-situ-Messung der Dicke der Oxidschicht ist durch den Einsatz eines integrierten Messsystems 11 möglich, wobei die aktuellen Messdaten sofort an die Steuereinheit 10 weitergegeben und verarbeitet werden können.

**Beispiel**

Behandelt wird eine SOI-Scheibe mit 300 mm Durchmesser, hergestellt durch Übertragung einer Siliciumschicht von einer Donorscheibe auf eine Trägerscheibe. Die Dicke der Scheibe beträgt 735 μm, die Dicke der Siliciumoxidschicht 80 nm, die Zieldicke der auf der Siliciumoxidschicht befindlichen Siliciumschicht 20nm.

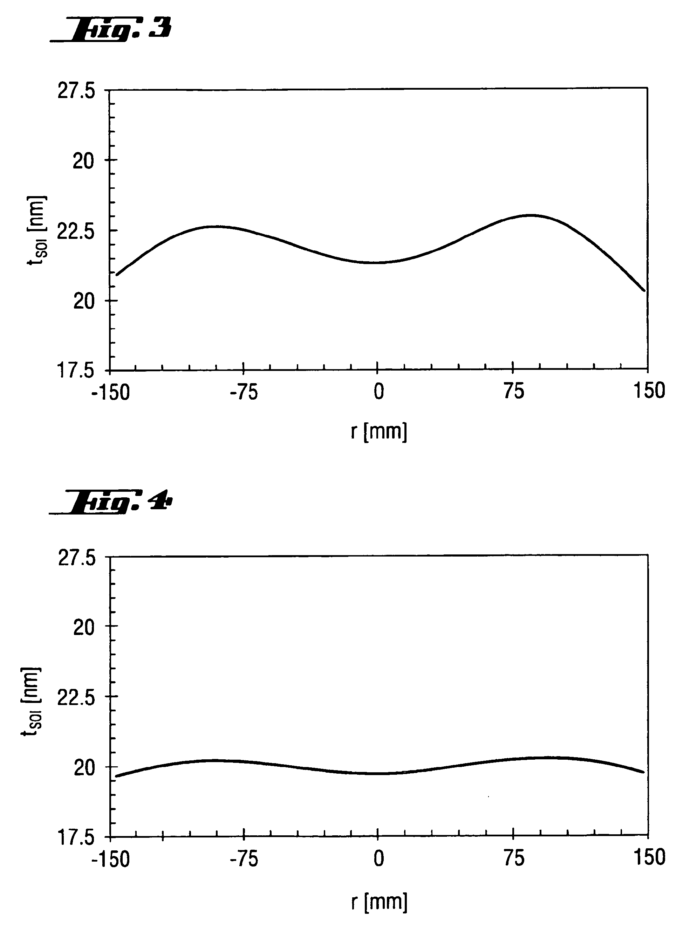

In Schritt a) wird die Dicke der Siliciumschicht mittels eines Interferometers ortsabhängig exakt vermessen. Die Messung mit 2000 Messpunkten und einem Randausschluss von 1 mm ergibt eine mittlere Schichtdicke von 21,9 nm mit einer Standardabweichung von 0,7 nm und einer Differenz von 2,8 nm zwischen maximaler und minimaler Schichtdicke. In Fig. 3 ist ein Dickenprofil entlang eines Durchmessers abgebildet, d. h. die Dicke $t_{SOI}$ der Siliciumschicht, gemessen in der Einheit nm, als Funktion der radialen Position r, gemessen in der Einheit mm. Die Dickenmesswerte werden in einem Computer gespeichert und in eine Graustufenkarte umgerechnet. Orte mit höherer Schichtdicke ergeben dabei einen höheren Transparenzanteil auf der Graustufenkarte, so dass an diesen Stellen eine höhere Belichtung erfolgt und damit eine höhere Abtragsrate erreicht wird und umgekehrt.

Anschließend wird in Schritt b) die Oxidationsbehandlung durchgeführt. Die frisch mit der RCA-Methode gereinigte SOI-Scheibe wird in die Oxidationskammer eingebracht und unter Stickstoff auf die Prozesstemperatur von 500 °C aufgeheizt. Bei Erreichen der Prozesstemperatur erfolgt der Prozessstart durch Umschalten auf Sauerstoff mit einem Fluss von 0,5 l/min bei Atmosphärendruck und Einschalten der ganzflächigen UV-Beleuchtung mit lokal unterschiedlicher Intensität. Als Belichtungsvorrichtung wird ein Array aus Niederdruck-Quecksilberlampen verwendet, wobei die emittierte Wellenlänge bei 185 nm genutzt wird. Der Abstand von den Lichtquellen zur Oberfläche der Siliciumschicht beträgt 10 cm. Die zuvor in Schritt a) errechnete Graustufenkarte wird nun mittels des Lichtquellenarrays auf die Oberfläche der Siliciumschicht abgebildet, wobei die Lampen einzeln entsprechend der Graustufenkarte angesteuert werden. Auf diese Weise wird die Oberfläche der Siliciumschicht mit lokal unterschiedlicher Lichtintensität bestrahlt. Die Lichtintensität an der Oberfläche der Siliciumschicht variiert ortsabhängig zwischen 1 und 30 mW/cm². Nach 60 min Oxidationszeit ergibt sich eine Oxidschichtdicke von 6,0 nm (entsprechend 2,88 nm aufoxidiertem Silicium) an der dicksten Stelle und eine Oxidschichtdicke von 1,8 nm (entsprechend 0,86 nm aufoxidiertem Silicium) an der dünnsten Stelle. Nach Ende der Oxidationszeit wird mit die Oxidationskammer mit Stickstoff gespült und die Scheibe aus der Oxidationskammer entnommen. Anschließend wird die Oxidschicht vollständig entfernt mittels nasschemischen Ätzens. Dazu wird eine wässrige Lösung verwendet, die 0,5 % Fluorwasserstoff (HF) enthält und mit 20 % Ammoniumfluorid ($NH_3F$) gepuffert ist. Die Behandlung mit dieser Lösung führt zu keiner messbaren Aufrauung der Oberfläche der Siliciumschicht.

Dann wird mit dem gleichen Dickenmessverfahren wie zu Beginn wiederum die ortsabhängige Dicke der Siliciumschicht vermessen. Die mittlere Schichtdicke beträgt jetzt 20,1 nm mit einer Standardabweichung von 0,21 nm und einer Differenz von 0,65 nm zwischen maximaler und minimaler Schichtdicke. Das Dickenprofil entlang des Durchmessers, Fig. 4, zeigt die deutliche Einebnung der Siliciumschicht.

**Patentansprüche**

1. Verfahren zur Behandlung einer Halbleiterscheibe, umfassend folgende Schritte in der angegebenen Reihenfolge:

a) ortsabhängige Messung eines die Halbleiterscheibe charakterisierenden Parameters, um den ortsabhängigen Wert dieses Parameters auf einer gesamten Fläche der Halbleiterscheibe zu ermitteln,
b) Oxidation dieser gesamten Fläche der Halbleiterscheibe bei einer Temperatur von 100 bis 1100 °C unter Einwirkung eines gasförmigen, Sauerstoff enthaltenden Oxidationsmittels und gleichzeitiger Belichtung dieser gesamten Fläche mit UV-Licht mit einer Wellenlänge von weniger als 250 nm, wobei die Oxidationsrate und damit die Dicke der resultierenden Oxidschicht von der Lichtintensität an der Fläche der Halbleiterscheibe abhängig ist, und
c) Entfernung der Oxidschicht,

wobei die Lichtintensität in Schritt b) ortsabhängig so vorgegeben wird, dass die Unterschiede in den in Schritt a) gemessenen ortsabhängigen Werten des Parameters durch die aus der ortsabhängigen Lichtintensität resultierende ortsabhängige Oxidationsrate in Schritt b) und die nachfolgende Entfernung der Oxidschicht in Schritt c) verringert werden.

2. Verfahren gemäß Anspruch 1, **dadurch gekennzeichnet, dass** die Belichtung der Halbleiterscheibe durch eine Lichtquelle und einen zwischen der Lichtquelle und der Halbleiterscheibe angebrachten Filter erfolgt, wobei der Filter eine ortsabhängige Lichtdurchlässigkeit besitzt, die in einem eindeutigen Zusammenhang mit dem ortsabhängigen Wert des Parameters steht.

3. Verfahren gemäß Anspruch 1, **dadurch gekennzeichnet, dass** aus dem in Schritt a) gemessenen ortsabhängigen Wert des Parameters mit Hilfe eines Computers eine Graustufenkarte berechnet wird und die Belichtung der Halbleiterscheibe in Schritt b) durch eine Projektionsvorrichtung erfolgt, die ein Bild dieser Graustufenkarte auf die Fläche der Halbleiterscheibe projiziert.

4. Verfahren gemäß Anspruch 1, **dadurch gekennzeichnet, dass** die Belichtung der Halbleiterscheibe (5) durch eine Vielzahl von Lichtquellen (2) erfolgt, die nebeneinander in einer parallel zur Ebene der Halbleiterscheibe (5) liegenden Ebene angeordnet sind, wobei die Lichtquellen einzeln oder in Gruppen so gesteuert werden, dass die an jedem Ort auf der Fläche der Halbleiterscheibe (5) einwirkende Lichtintensität in einem eindeutigen Zusammenhang mit dem ortsabhängigen Wert des Parameters steht.

5. Verfahren gemäß einem der Ansprüche 1 bis 4, **dadurch gekennzeichnet, dass** das Oxidationsmittel Sauerstoff, Ozon oder ein Stickstoffoxid ist.

6. Verfahren gemäß einem der Ansprüche 1 bis 5, **dadurch gekennzeichnet, dass** die Halbleiterscheibe aus einem Material besteht, das aus der Gruppe: Silicium-Germanium und Siliciumcarbid ausgewählt ist.

7. Verfahren gemäß Anspruch 5, **dadurch gekennzeichnet, dass** die Halbleiterscheibe aus Silicium besteht.

8. Verfahren gemäß einem der Ansprüche 1 bis 7, **dadurch gekennzeichnet, dass** der Parameter die Höhenabweichung von einer definierten Idealebene ist.

9. Verfahren gemäß einem der Ansprüche 1 bis 5, **dadurch gekennzeichnet, dass** die Halbleiterscheibe eine SOI-Scheibe ist, die eine Halbleiterschicht auf einem elektrisch isolierenden Träger umfasst.

10. Verfahren gemäß Anspruch 9, **dadurch gekennzeichnet, dass** die Halbleiterschicht aus einem Material besteht, das aus der Gruppe: Silicium-Germanium und Siliciumcarbid ausgewählt ist.

11. Verfahren gemäß Anspruch 9, **dadurch gekennzeichnet, dass** die Halbleiterschicht aus Silicium besteht.

12. Verfahren gemäß einem der Ansprüche 9 bis 11, **dadurch gekennzeichnet, dass** der Parameter die Dicke der Halbleiterschicht ist.

EP 1 857 576 B1

**Claims**

1. Method for the treatment of a semiconductor wafer, comprising the following steps in the stated order:

   a) location-dependent measurement of a parameter which characterizes the semiconductor wafer in order to determine the location-dependent value of said parameter over an entire surface of the semiconductor wafer,
   b) oxidation of said entire surface of the semiconductor wafer at a temperature of 100 to 1100°C under the action of a gaseous, oxygen-containing oxidizing agent and simultaneous exposure of said entire surface with UV light having a wavelength of less than 250 nm, the oxidation rate and thus the thickness of the resulting oxide layer being dependent on the light intensity at the surface of the semiconductor wafer, and
   c) removal of the oxide layer,

   the light intensity in step b) being predefined in a location-dependent manner in such a way that the differences in the location-dependent values of the parameter measured in step a) are reduced by the location-dependent oxidation rate resulting from the location-dependent light intensity in step b) and the subsequent removal of the oxide layer in step c).

2. Method according to Claim 1, **characterized in that** the exposure of the semiconductor wafer is effected by a light source and a filter fitted between the light source and the semiconductor wafer, the filter having a location-dependent light transmissivity which is in a defined relationship with the location-dependent value of the parameter.

3. Method according to Claim 1, **characterized in that** a grayscale map is calculated with the aid of a computer from the location-dependent value of the parameter measured in step a), and the exposure of the semiconductor wafer in step b) is effected by a projection apparatus which projects an image of said grayscale map onto the surface of the semiconductor wafer.

4. Method according to Claim 1, **characterized in that** the exposure of the semiconductor wafer (5) is effected by a multiplicity of light sources (2) which are arranged alongside one another in a plane lying parallel to the plane of the semiconductor wafer (5), the light sources being controlled individually or in groups in such a way that the light intensity acting on the surface of the semiconductor wafer (5) at each location is in a defined relationship with the location-dependent value of the parameter.

5. Method according to one of Claims 1 to 4, **characterized in that** the oxidizing agent is oxygen, ozone or a nitrogen oxide.

6. Method according to one of Claims 1 to 5, **characterized in that** the semiconductor wafer comprises a material selected from the group: silicon-germanium and silicon carbide.

7. Method according to Claim 5, **characterized in that** the semiconductor wafer comprises silicon.

8. Method according to one of Claims 1 to 7, **characterized in that** the parameter is the height deviation from a defined ideal plane.

9. Method according to one of Claims 1 to 5, **characterized in that** the semiconductor wafer is an SOI wafer which comprises a semiconductor layer on an electrically insulating carrier.

10. Method according to Claim 9, **characterized in that** the semiconductor layer comprises a material selected from the group: silicon-germanium and silicon carbide.

11. Method according to Claim 9, **characterized in that** the semiconductor layer comprises silicon.

12. Method according to one of Claims 9 to 11, **characterized in that** the parameter is the thickness of the semiconductor layer.

**Revendications**

1. Procédé de traitement d'une plaque semi-conductrice, comprenant les étapes suivantes dans la succession

13

indiquée :

a) mesure locale d'un paramètre qui caractérise la plaque semi-conductrice pour déterminer la valeur locale de ce paramètre sur toute la surface de la plaque semi-conductrice,

b) oxydation de la totalité de la surface de la plaque semi-conductrice à une température de 100 à 1 100°C sous l'action d'un agent oxydant gazeux contenant de l'oxygène et en même temps éclairage de la totalité de cette surface par de la lumière UV d'une longueur d'onde inférieure à 250 nm, le taux d'oxydation et donc l'épaisseur de la couche d'oxyde ainsi obtenue dépendant de l'intensité de la lumière sur la surface de la plaque semi-conductrice et

c) enlèvement de la couche d'oxyde,

l'intensité de l'étape b) étant prédéterminée localement de telle sorte que les différences entre les valeurs locales, mesurées à l'étape a), du paramètre soient diminuées par le taux d'oxydation local qui résulte à l'étape b) de l'intensité locale de la lumière et que l'enlèvement ultérieur de la couche d'oxyde réalisé à l'étape c) soit diminué.

2. Procédé selon la revendication 1, **caractérisé en ce que** l'éclairage de la plaque semi-conductrice s'effectue au moyen d'une source de lumière et d'un filtre placé entre la source de lumière et la plaque semi-conductrice, la transparence locale à la lumière du filtre étant associée de manière univoque à la valeur locale du paramètre.

3. Procédé selon la revendication 1, **caractérisé en ce qu'**à partir de la valeur locale, mesurée à l'étape a), du paramètre, une carte en niveaux de gris est calculée à l'aide d'un ordinateur et l'éclairage de la plaque semi-conductrice à l'étape b) s'effectue par un dispositif de projection qui projette sur la surface de la plaque semi-conductrice une image de cette carte en niveaux de gris.

4. Procédé selon la revendication 1, **caractérisé en ce que** l'éclairage de la plaque semi-conductrice (5) s'effectue par plusieurs sources de lumière (2) disposées les unes à côté des autres dans un plan parallèle au plan de la plaque semi-conductrice (5), les sources de lumière étant commandées individuellement ou en groupes de telle sorte que l'intensité de la lumière qui agit en chaque emplacement de la surface de la plaque semi-conductrice (5) soit en relation univoque avec la valeur locale du paramètre.

5. Procédé selon l'une des revendications 1 à 4, **caractérisé en ce que** l'agent d'oxydation est l'oxygène, l'ozone ou un oxyde d'azote.

6. Procédé selon l'une des revendications 1 à 5, **caractérisé en ce que** la plaque semi-conductrice est constituée d'un matériau sélectionné dans l'ensemble constitué du silicium-germanium et du carbure de silicium.

7. Procédé selon la revendication 5, **caractérisé en ce que** la plaque semi-conductrice est constituée de silicium.

8. Procédé selon l'une des revendications 1 à 7, **caractérisé en ce que** le paramètre est l'écart en hauteur par rapport à un plan idéal défini.

9. Procédé selon l'une des revendications 1 à 5, **caractérisé en ce que**l la plaque semi-conductrice est une plaque SOI qui comprend une couche semi-conductrice sur un support électriquement isolant.

10. Procédé selon la revendication 9, **caractérisé en ce que** la couche semi-conductrice est constituée d'un matériau sélectionné dans l'ensemble silicium-germanium et carbure de silicium.

11. Procédé selon la revendication 9, **caractérisé en ce que** la plaque semi-conductrice est constituée de silicium.

12. Procédé selon l'une des revendications 9 à 11, **caractérisé en ce que** le paramètre est l'épaisseur de la plaque semi-conductrice.

Fig. 1

Fig. 2

## Fig. 3

## Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 798766 A1
- EP 961314 A1
- EP 1100117 A2
- US 20040063329 A1
- EP 488642 A2
- EP 511777 A1
- US 20060097355 A
- JP 09232279 B
- JP 09008258 B

**In der Beschreibung aufgeführte Nicht-Patentliteratur**

- A New Method for the Precise Measurement of Wafer Roll off of Silicon Polished Wafer. *Jpn.J.Appl.Phys.,* 1999, vol. 38, 38-39
- **Young et al.** *Applied Physic Letters,* 1987, vol. 50 (2), 80
- **Kazor et al.** *Applied Surface Science,* 1992, vol. 54, 460-464
- **Boyd et al.** *Nuclear Instruments and Methods in Physic Research B,* 1997, vol. 121, 349-356
- **Ishikawa et al.** *Jpn. J. Appl. Phys.,* 1991, vol. 30, L661
- **Young et al.** *Applied Physics Letters,* 1987, vol. 50 (2), 12
- **Boyd et al.** *Nuclear Instruments and Methods in Physics Research B,* 1997, vol. 121, 349-356
- **Oren et al.** *Journal of applied Physics,* 1971, vol. 42 (2), 752-756
- **Young et al.** *Applied Physics Letters,* 1987, vol. 50 (2), 80